(19) Europäisches Patentamt
European Patent Office
Office européen des brevets

(11) EP 2 219 174 B1

(12) EUROPEAN PATENT SPECIFICATION

(45) Date of publication and mention
of the grant of the patent:
**16.11.2011 Bulletin 2011/46**

(51) Int Cl.:
*G09G 3/32* (2006.01)

(21) Application number: **10151624.3**

(22) Date of filing: **26.01.2010**

(54) **Pixel and organic light emitting display device using the same**

Pixel und organische lichtemittierende Anzeigevorrichtung damit

Pixel et dispositif d'affichage électroluminescent organique l'utilisant

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(30) Priority: **11.02.2009 KR 20090011017**

(43) Date of publication of application:
**18.08.2010 Bulletin 2010/33**

(73) Proprietor: **Samsung Mobile Display Co., Ltd.**
**Yongin-city, Gyunggi-do 446-711 (KR)**

(72) Inventors:
• **Han, Sam-Il**
**Chungcheongnam (KR)**
• **Bang, Hyun-Chol**
**Chungcheongnam (KR)**

(74) Representative: **Walaski, Jan Filip et al**
**Venner Shipley LLP**
**20 Little Britain**
**London**
**EC1A 7DH (GB)**

(56) References cited:
EP-A2- 1 923 857      WO-A1-2006/067706
US-A1- 2003 201 727   US-A1- 2006 221 006
US-A1- 2008 211 397

**Description**

The invention relates to a pixel and an organic light emitting display device using the same, and more particularly, to a pixel capable of compensating for deterioration of an organic light emitting diode and an organic light emitting display device using the pixel.

There are various types of flat panel display devices having reduced weight and volume when compared to cathode ray tubes. The flat panel display devices include liquid crystal display devices, field emission display devices, plasma display panels, organic light emitting display devices, and the like.

An organic light emitting display device displays images using organic light emitting diodes that emit light through recombination of electrons and holes. The organic light emitting display device has a fast response and is driven with low power consumption.

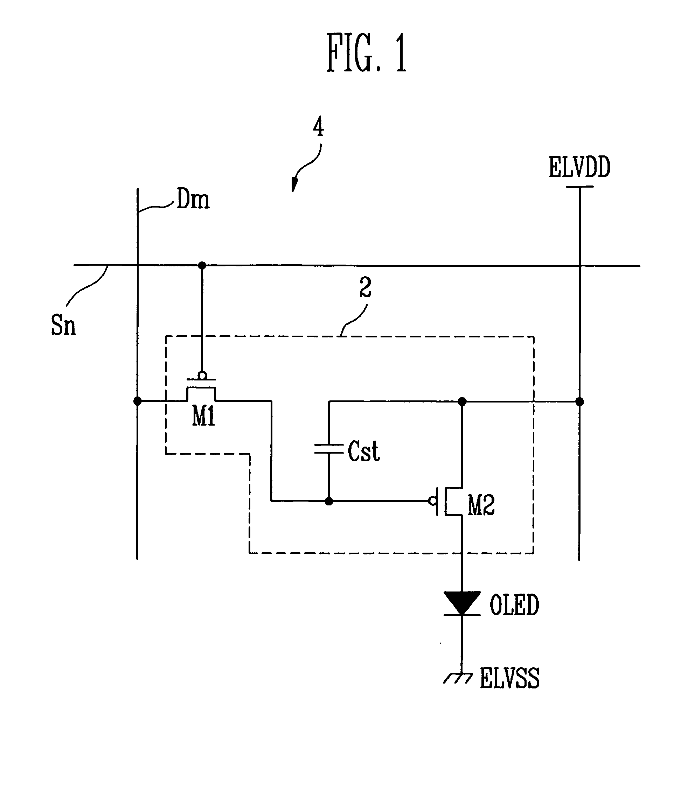

FIG. 1 is a circuit diagram of a pixel of a conventional organic light emitting display device.

Referring to FIG. 1, the pixel 4 of the conventional organic light emitting display device includes an organic light emitting diode OLED and a pixel circuit 2 connected to a data line Dm and a scan line Sn to control the organic light emitting diode OLED.

An anode electrode of the organic light emitting diode OLED is coupled to the pixel circuit 2, and a cathode electrode of the organic light emitting diode OLED is coupled to a second power source ELVSS. The organic light emitting diode OLED emits light having luminance corresponding to current supplied from the pixel circuit 2.

When a scan signal is supplied to the pixel circuit 2 through the scan line Sn, the pixel circuit 2 controls an amount of current supplied to the organic light emitting diode OLED in response to a data signal supplied through the data line Dm. For this purpose, the pixel circuit 2 includes a second transistor M2 coupled between a first power source ELVDD and the organic light emitting diode OLED, a first transistor M1 coupled to the second transistor M2, the data line Dm, and the scan line Sn, and a storage capacitor Cst coupled between a gate electrode and a second electrode of the second transistor M2.

A gate electrode of the first transistor M1 is coupled to the scan line Sn, and a first electrode of the first transistor M1 is coupled to the data line Dm. A second electrode of the first transistor M1 is coupled to one terminal of the storage capacitor Cst. Here, the first electrode is either of a source and a drain electrode, and the second electrode is the other. For example, if the first electrode is a source electrode, the second electrode is a drain electrode. When a scan signal is supplied to the first transistor M1 from the scan line Sn, the first transistor M1 is turned on so that a data signal supplied from the data line Dm is supplied to the storage capacitor Cst. As a result, the storage capacitor Cst stores a voltage corresponding to the data signal.

The gate electrode of the second transistor M2 is coupled to the terminal of the storage capacitor Cst, and a first electrode of the second transistor M2 is coupled to the other terminal of the storage capacitor Cst and the first power source ELVDD. The second electrode of the second transistor M2 is coupled to the anode electrode of the organic light emitting diode OLED. The second transistor M2 controls an amount of current flowing from the first power source ELVDD to the second power source ELVSS via the organic light emitting diode OLED, corresponding to the voltage stored in the storage capacitor Cst. As a result, the organic light emitting diode OLED emits light corresponding to an amount of current supplied from the second transistor M2.

However, in the conventional organic light emitting display device, an image having a desired luminance cannot be displayed due to efficiency variation caused by deterioration of the organic light emitting diode OLED. In other words, the organic light emitting diode deteriorates with time, and accordingly, an image having a desired luminance cannot be displayed. As an organic light emitting diode deteriorates, light having low luminance is emitted from the organic light emitting diode.

US 2008/211397 A1 and EP 1923857 A2 disclose an organic light emitting display using a pixel and a circuit driving method for the pixel which may compensate for degradation of an organic light emitting diode.

According to the present invention, there is provided a pixel according to claim 1 and an organic light emitting display device including the pixel.

One aspect is a pixel including an organic light emitting diode configured to emit light in response to a data signal, a dummy organic light emitting diode in a non-light emitting state regardless of the data signal, a first transistor coupled to scan and data lines, the first transistor being turned on when a scan signal is supplied to the scan line, a storage capacitor configured to charge a voltage corresponding to the data signal supplied to the data line, a second transistor configured to supply current from a first power source to a second power source through the organic light emitting diode, where the current corresponds to the voltage charged in the storage capacitor, and a compensator coupled between the organic light emitting diode and the dummy organic light emitting diode, the compensator configured to change a voltage at a gate electrode of the second transistor according to the difference in threshold voltages of the organic light emitting diode and the dummy organic light emitting diode.

Another aspect is an organic light emitting display device, including pixels coupled to scan lines and data lines, a scan driver configured to sequentially supply a scan signal to the scan lines, and a data driver configured to supply a data signal to the data lines. Each of the pixels includes an organic light emitting diode configured to emit light in response to the data signal, a dummy organic light emitting diode in a non-light emitting state regardless of the data signal, a first transistor coupled to scan and data lines, the first transistor being turned on when a scan signal is supplied to the scan line, a storage capacitor configured to charge a voltage corresponding to the data signal supplied to the data line, a second transistor configured to supply current from a first power source to a second power source through the organic light emitting diode, where the current corresponds to the voltage charged in the storage capacitor, and a compensator coupled between the organic light emitting diode and the dummy organic light emitting diode, the compensator configured to change a voltage at a gate electrode of the second transistor according to the difference in threshold voltages of the organic light emitting diode and the dummy organic light emitting diode.

Another aspect is a pixel including an organic light emitting diode configured to emit light in response to a current supplied thereto, a dummy organic light emitting diode, a transistor configured to supply current to the organic light emitting diode based at least in part on a gate voltage, and a compensator configured to change the gate voltage according to the difference in threshold voltages of the organic light emitting diode and the dummy organic light emitting diode.

The accompanying drawings, together with the specification, illustrate exemplary embodiments, and, together with the description, serve to explain the principles of the present invention.

FIG. 1 is a circuit diagram of a pixel in a conventional organic light emitting display device.
FIG. 2 is a block diagram of an organic light emitting display device according to one embodiment.
FIG. 3 is a circuit diagram showing an embodiment of a pixel shown in FIG. 2.
FIG. 4 is a circuit diagram showing an embodiment of a compensator shown in
FIG. 3.

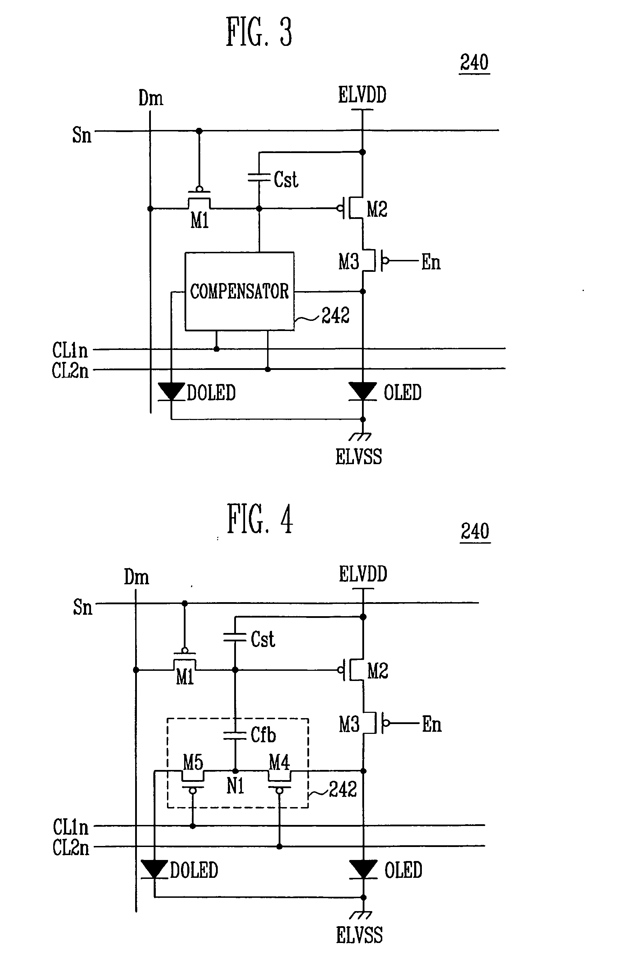

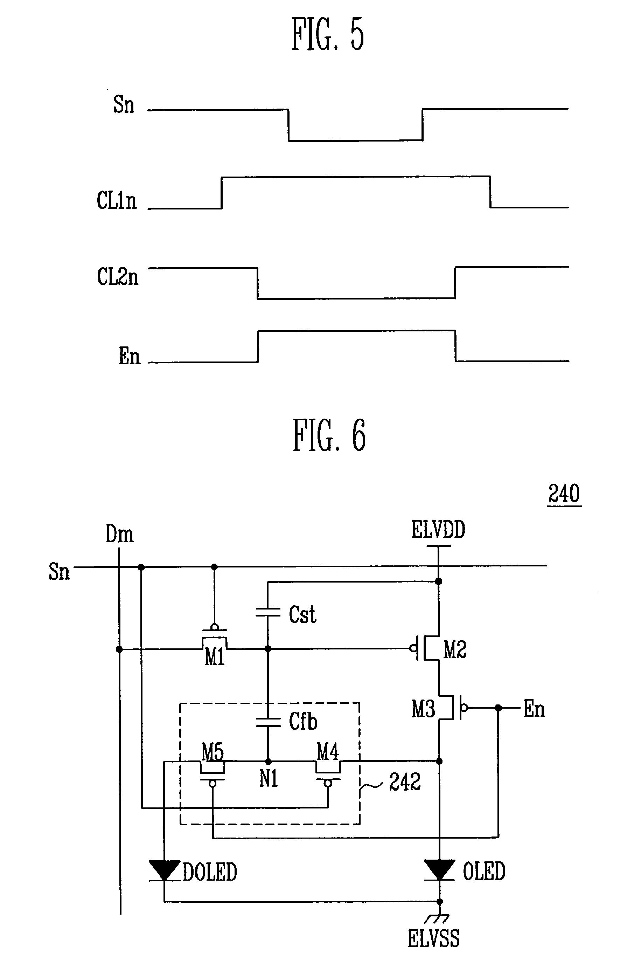

FIG. 5 is a waveform diagram illustrating a method of driving a pixel shown in FIG. 4.
FIG. 6 is a circuit diagram showing another embodiment of the compensator shown in FIG. 3.

Hereinafter, certain exemplary embodiments will be described with reference to the accompanying drawings. When a first element is described as being coupled to a second element, the first element may be not only directly coupled to the second element but may also be indirectly coupled to the second element via a third element. Also, like reference numerals generally refer to like elements throughout.

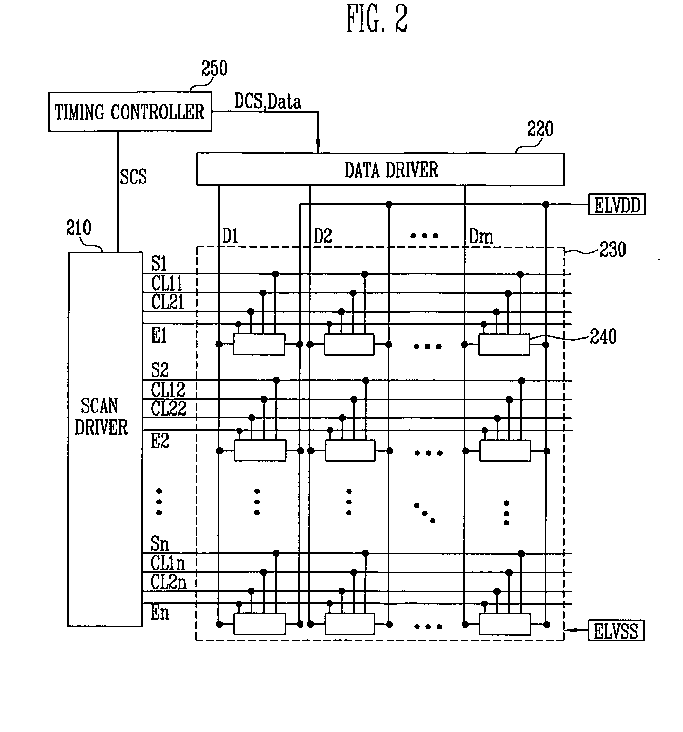

FIG. 2 is a block diagram of an organic light emitting display device according to an embodiment.

Referring to FIG. 2, an organic light emitting display device includes a pixel unit 230 including pixels 240 coupled to scan lines S1 to Sn, first control lines CL11 to CL1n, second control lines CL21 to CL2n, emission control lines E1 to En and data lines D1 to Dm; a scan driver 210 to drive the scan lines S1 to Sn, the first control lines CL11 to CL1n, the second control lines CL21 to CL2n and the emission control lines E1 to En; a data driver 220 to drive the data lines D1 to Dm; and a timing controller 250 to control the scan driver 210 and the data driver 220.

The scan driver 210 receives a scan driving control signal SCS supplied from the timing controller 250. The scan driver 210 generates a scan signal and sequentially supplies the generated scan signal to the scan lines S1 to Sn. The scan driver 210 generates first and second control signals in response to the scan driving control signal SCS. The scan driver sequentially supplies the generated first control signal to the first control lines CL11 to CL1n and sequentially supplies the generated second control signal to the second control lines CL21 to CL2n. The scan driver 210 generates an emission control signal and sequentially supplies the generated emission control signal to the emission control lines E1 to En.

An embodiment of a drive scheme is shown in FIG. 5. The emission control signal is wider than the scan signal. The emission control signal supplied to an i-th ("i" is a natural number) emission control line Ei overlaps the scan signal supplied to an i-th scan line Si. The first control signal supplied to an i-th first control line CL1i is wider than the emission control signal and overlaps the emission control signal supplied to the i-th emission control line Ei. The second control signal supplied to an i-th second control line CL2i is simultaneously supplied to have the same width as that of the emission control signal and has an opposite polarity to that of the emission control signal.

The first control lines CL11 to CL1n and the second control lines CL21 to CL2n may be omitted depending on the structure of pixels 240.

The data driver 220 receives a data driving control signal DCS supplied from the timing controller 250. The data driver 220 generates data signals and supplies the generate data signals to the data lines D1 to Dm in synchronization with scan signals.

The timing controller 250 generates a data driving control signal DCS and a scan driving control signal SCS in response to synchronization signals supplied thereto. The data driving control signal DCS generated from the timing controller 250 is supplied to the data driver 220, and the scan driving control signal SCS generated from the timing controller 250 is supplied to the scan driver 210. The timing controller 250 supplies data Data supplied from the outside to the data driver 220.

The pixel unit 230 receives a first power source ELVDD and a second power source ELVSS, and supplies the first power source ELVDD and the second power source ELVSS to each of the pixels 240. Each of the pixels 240 receiving the first power source ELVDD and the second power source ELVSS generates light in response to a data signal. Each of the pixels 240 is provided with a compensator (not shown) to compensate for deterioration of an organic light emitting diode.

FIG. 3 is a circuit diagram of a pixel according to one embodiment. For convenience of illustration, a pixel coupled to an n-th scan line Sn and an m-th data line Dm is shown in FIG. 3.

Referring to FIG. 3, in this embodiment, the pixel 240 includes an organic light emitting diode OLED; a first transistor M1 coupled to a scan line Sn and a data line Dm; a second transistor M2 controlling an amount of current supplied to the organic light emitting diode OLED corresponding to a voltage charged in a storage capacitor Cst; a third transistor M3 coupled between the organic light emitting diode OLED and the second transistor M2; and a compensator 242 coupled between the organic light emitting diode OLED and a dummy organic light emitting diode DOLED so as to compensate for deterioration of the organic light emitting diode OLED.

An anode electrode of the organic light emitting diode OLED is coupled to the third transistor M3, and a cathode electrode of the organic light emitting diode OLED is coupled to the second power source ELVSS. The organic light emitting diode OLED emits light having a luminance corresponding to current supplied via the second transistor and the third transistor M3.

A gate electrode of the first transistor M1 is coupled to the scan line Sn, and a first electrode of the first transistor M1 is coupled to the data line Dm. A second electrode of the first transistor M1 is coupled to a gate electrode of the second transistor M2 (driving transistor). When a scan signal is supplied to the scan line Sn, the first transistor M1 supplies a data signal supplied to the data line Dm to the gate electrode of the second transistor M2.

The gate electrode of the second transistor M2 is coupled to the second electrode of the first transistor M1, and a first electrode of the second transistor M2 is coupled to a first power source ELVDD. A second electrode of the second transistor M2 is coupled to a first electrode of the third transistor M3. The second transistor M2 controls an amount of current flowing from the first power source ELVDD to the second power source ELVSS through the organic light emitting diode OLED, corresponding to the voltage applied to the gate electrode of the second transistor M2.

A gate electrode of the third transistor M3 is coupled to an emission control line En, and the first electrode of the third transistor M3 is coupled to the second electrode of the second transistor M2. A second electrode of the third transistor M3 is coupled to an anode electrode of the organic light emitting diode OLED. When an emission control signal is supplied from the emission control line En, the third transistor M3 is turned off. In other cases, the third transistor M3 is turned on. The third transistor M3 is turned off during at least a period when a scan signal is supplied so that the pixel 240 is in a non-light emission state.

One terminal of the storage capacitor Cst is coupled to the gate electrode of the second transistor M2, and the other terminal of the storage capacitor Cst is coupled to the first power source ELVDD. When the first transistor M1 is turned on, a voltage corresponding to the data signal is charged in the storage capacitor Cst. The compensator 242 is coupled between the dummy organic light emitting diode DOLED and the organic light emitting diode OLED. The compensator 242 controls the voltage at the gate electrode of the second transistor M2 so as to compensate for the deterioration of the organic light emitting diode OLED.

FIG. 4 is a circuit diagram showing a first embodiment of the compensator shown in FIG. 3.

Referring to FIG. 4, the compensator 242 according to one embodiment includes fourth and fifth transistors M4 and M5 coupled between the organic light emitting diode OLED and the dummy organic light emitting diode DOLED; and a feedback capacitor Cfb coupled between a first node N1 and the gate electrode of the second transistor M2.

The fourth transistor M4 is coupled between the first node N1 and the anode electrode of the organic light emitting diode OLED and is controlled by the second control signal supplied from a second control line CL2n.

The fifth transistor M5 is coupled between the first node N1 and the dummy organic light emitting diode DOLED and is controlled by the first control signal supplied from a first control line CL1n. The fourth and fifth transistors M4 and M5 are used to supply a voltage to the first node N1, and the turned-on times of the fourth and fifth transistors M4 and M5 do not overlap. For example, the fourth and fifth transistors M4 and M5 are alternately turned on to control the voltage at the first node N1.

The feedback capacitor Cfb couples a voltage variation at the first node N1 to the gate electrode of the second transistor M2.

FIG. 5 is a waveform diagram illustrating a method of driving the pixel shown in FIG. 4.

An operation of the pixel 240 shown in FIG. 4 will be described in conjunction with FIGS. 4 and 5. First, a first control signal (high voltage) is supplied to the first control line CL1n, and the fifth transistor is off. Because the fifth transistor M5 is turned off, the first node N1 and the dummy organic light emitting diode DOLED are electrically isolated.

While the fifth transistor M5 is off, a second control signal (low voltage) is supplied to the second control line CL2n, and an emission control signal (high voltage) is simultaneously supplied to the emission control line En. Because the emission control signal is supplied to the emission control line En, the third transistor M3 is off. Because the second control signal is supplied to the second control line CL2n, the fourth transistor M4 is on, and the threshold voltage Vth1 of the organic light emitting diode OLED is supplied to the first node N1. That is, since the third transistor M3 is turned off, the threshold voltage Vth1 of the organic light emitting diode OLED is supplied to the first node N1.

Thereafter, a scan signal is supplied to the scan line Sn, and the first transistor M1 is turned on. Because the first transistor M1 is on, a voltage corresponding to a data signal supplied to the data line Dm is charged in the storage capacitor Cst. After the voltage corresponding to the data signal is charged in the storage capacitor Cst, the scan signal is suspended, and the first transistor M1 is turned off.

After the first transistor M1 is turned off, the second control signal and the emission control signal is suspended. Because the second control signal is suspended, the fourth transistor M4 is turned off. Because the emission control signal is suspended, the third transistor M3 is turned on.

Thereafter, the first control signal is suspended, and the fifth transistor M5 is turned on. Because the fifth transistor is turned on, the voltage at the first node N1 changes to the threshold voltage Vth2 of the dummy organic light emitting diode DOLED. The amount of change is determined by the difference between the threshold voltage Vth1 of the organic light emitting diode OLED and the threshold voltage Vth2 of the dummy organic light emitting diode DOLED. The difference between the thresholds is determined by the deterioration of the organic light emitting diode OLED.

The deterioration of the organic light emitting diode OLED corresponds to its emission time. When the organic light emitting diode OLED deteriorates, the threshold voltage Vth1 of the organic light emitting diode OLED changes. The voltage Vth1 of the organic light emitting diode OLED generally rises.

Meanwhile, the dummy organic light emitting diode DOLED maintains a non-emission state regardless of the data signal. Therefore, the dummy organic light emitting diode DOLED does not deteriorate, and maintains the initial threshold voltage Vth2. Accordingly, when the threshold voltage Vth2 of the dummy organic light emitting diode DOLED is supplied to the first node N1, the voltage at the first node N1 drops from the voltage Vth1 of the organic light emitting diode OLED to the threshold voltage Vth2 of the dummy organic light emitting diode DOLED.

Because the voltage at the first node N1 drops, the voltage at the gate electrode of the second transistor M2 also drops. The reduction of the voltage at the gate electrode of the second transistor M2 is approximated by Equation 1.

$$\Delta V_{M2\_gate} = \Delta V_{N1} \times \left( C_{fb} / \left( C_{st} + C_{fb} \right) \right) \qquad (1)$$

In Equation 1, $\Delta V_{M2\_gate}$ denotes a variation of the voltage at the gate electrode of the second transistor M2, and $\Delta V_{N1}$ denotes a variation of the voltage at the first node N1.

Referring to Equation 1, the gate electrode of the second transistor M2 is changed corresponding to the variation of the voltage at the first node N1. That is, when the voltage at the first node N1 drops, the voltage at the gate electrode of the second transistor M2 also drops. Thereafter, the second transistor M2 supplies current corresponding to the voltage applied to the gate electrode of the second transistor M2 from the first power source ELVDD to the second power source ELVSS through the organic light emitting diode OLED. As a result, light corresponding to the current is emitted from the organic light emitting diode OLED.

With continued use, the threshold voltage Vth1 of the organic light emitting diode OLED rises according to the deterioration of the organic light emitting diode OLED. If the threshold voltage Vth1 of the organic light emitting diode OLED rises, the voltage at the first node N1 is further reduced.

If the reduction of the voltage at the first node N1 increases, the reduction of the voltage at the gate electrode of the second transistor M2 increases, as expressed by Equation 1. As a result, an amount of current supplied to the second transistor M2 increases according to the same data signal. That is, as the organic light emitting diode OLED is deteriorated, the amount of current supplied to the second transistor M2 is increased, thereby compensating for luminance degraded by the deterioration of the organic light emitting diode OLED.

Because the dummy organic light emitting diode DOLED coupled to the second ELVSS is used, the voltage at the gate electrode of the second transistor M2 can be controlled regardless of a possible voltage change in the second power source ELVSS. The variation of the voltage at the first node N1 is expressed by Equation 2.

$$\Delta V_{N1} = \left( ELVSS + Vth1 \right) - \left( ELVSS + Vth2 \right) \qquad (2)$$

In Equation 2, $\Delta V_{N1}$ denotes a variation of the voltage at the first node N1.

Referring to Equation 2, the variation of the voltage at the first node N1 is determined by the threshold voltage Vth1 of the organic light emitting diode OLED and the threshold voltage Vth2 of the dummy organic light emitting diode DOLED, and is independent of the voltage of the second power source ELVSS. Accordingly, the voltage at the gate electrode of the second transistor M2 can be adjusted using the voltage corresponding to the deterioration of the organic light emitting diode OLED, regardless of the voltage drop of the second power source ELVSS. FIG. 6 is a circuit diagram showing a second embodiment of the compensator shown in FIG. 3. In FIG. 6, detailed descriptions for certain aspects of some components similar to those of FIG. 4 will be omitted.

Referring to FIG. 6, the compensator 242 includes fourth and fifth transistors M4 and M5 coupled between the dummy organic light emitting diode DOLED and the organic light emitting diode OLED; and a feedback capacitor Cfb coupled between the first node N1 and the gate electrode of the second transistor M2.

The fourth transistor M4 is coupled between the first node N1 and the anode electrode of the organic light emitting diode OLED. The fourth transistor M4 is controlled by the scan signal supplied from the scan line Sn.

The fifth transistor M5 is coupled between the first node N1 and the dummy organic light emitting diode DOLED. The fifth transistor M5 is controlled by the emission control signal supplied from the emission control line En.

In the compensator 242 according to the embodiment of FIG. 6, the first and second control lines CL1n and CL2n can be removed as compared with the compensator 242 shown in FIG. 4. This is achieved because the compensator 242 of FIG. 6 is coupled to the scan line Sn and the emission control line En to compensate for deterioration of the organic light emitting diode OLED.

Operation of the pixel 240 will be described using the scan signal and the emission control signal, shown in FIG. 5. First, the emission control signal is supplied to the emission control line En. Because the emission control signal is supplied to the emission control line En, the third and fifth transistors M3 and M5 are turned off when the emission control signal is high.

The scan signal is supplied to the scan line Sn, and the first and fourth transistors M1 and M4 are turned on. Because the first transistor M1 is turned on, a voltage corresponding to a data signal supplied to the data line Dm is charged in the storage capacitor Cst. Because the fourth transistor M4 is turned on, the threshold voltage Vth1 of the organic light emitting diode OLED is supplied to the first node N1. After the voltage corresponding to the data signal is charged in the storage capacitor Cst, the supply of the scan signal is suspended, and the first and fourth transistors M1 and M4 are turned off.

After the first and fourth transistors M1 and M4 are turned off, the supply of the emission control signal to the emission control line En is suspended. Because the supply of the emission control signal is suspended, the fifth transistor M5 is turned on, and the voltage at the first node N1 drops to the threshold voltage Vth2 of the dummy organic light emitting diode DOLED. Because the voltage at the first node N1 drops to the threshold voltage Vth2 of the dummy organic light emitting diode DOLED, the voltage at the gate electrode of the second transistor M2 also drops as expressed by Equation 1. Here, since the reduction of the voltage at the gate electrode of the second transistor M2 is determined according to the deterioration of the organic light emitting diode OLED, the deterioration of the organic light emitting diode OLED is compensated.

The structure of the pixel 240 is not limited to those of FIGS. 4 and 6. A compensator 242 can be applied to various types of pixel circuits.

While certain inventive embodiments have been described, it is to be understood that the invention is not limited to the disclosed embodiments, but, on the contrary, is intended to cover various modifications and equivalent arrangements falling within the scope of the appended claims.

**Claims**

1. A pixel (240) comprising:

    an organic light emitting diode OLED configured to emit light in response to a data signal;
    a dummy organic light emitting diode DOLED configured to be in a substantially non-light emitting state that is independent of the data signal;
    a transistor (M2) having a gate electrode and configured to supply current to the organic light emitting diode in response to the data signal; and
    a compensator (242) coupled to the dummy organic light emitting diode;
    **characterised in that**
    the compensator is configured to change a voltage at the gate electrode in accordance with the difference in threshold voltages of the organic light emitting diode and the dummy organic light emitting diode.

2. The pixel of claim 1, wherein the transistor comprises a second transistor (M2), the pixel further comprising:

    a first transistor (M1) coupled to scan and data lines, the first transistor being turned on when a scan signal is supplied to the scan line;

a storage capacitor (Cst) configured to charge to a voltage corresponding to the data signal supplied to the data line;

wherein the compensator is coupled between the organic light emitting diode and the dummy organic light emitting diode.

3. The pixel of claim 2, further comprising a third transistor (M3) coupled between the second transistor (M2) and the organic light emitting diode, the second transistor being turned off while the scan signal is supplied.

4. The pixel of claim 3, wherein the third transistor is coupled to an emission control line, wherein the third transistor is turned off when an emission control signal is supplied to the emission control line.

5. The pixel of claim 4, wherein the emission control signal is wider than the scan signal, and overlaps the scan signal.

6. The pixel of any one of claims 2 to 5, wherein the compensator comprises:

fourth and fifth transistors (M4, M5) coupled between the organic light emitting diode and the dummy organic light emitting diode; and

a feedback capacitor (Cfb) coupled between the gate electrode of the second transistor and a common node of the fourth and fifth transistors.

7. The pixel of claim 6, wherein the turned-on times of the fourth and fifth transistors do not overlap.

8. The pixel of claim 7, wherein the fourth transistor is turned on during a period when the voltage corresponding to the data signal is charged in the storage capacitor and when a threshold voltage of the organic light emitting diode is supplied to the node.

9. The pixel of claim 8, wherein the fifth transistor is turned on during a period when the fourth transistor is turned off and when a threshold voltage of the dummy organic light emitting diode is supplied to the node.

10. The pixel of any one of claims 6 to 9, wherein the feedback capacitor is arranged to receive the threshold voltage of the organic light emitting diode according to a first signal, and to receive the threshold voltage of the dummy organic light emitting diode according to a second signal.

11. The pixel of claim 10, wherein the first signal is a scan signal and the second signal is an emission control signal.

12. The pixel of claim 10, wherein the first signal (CL1n) has the same polarity as the emission control signal and is wider than the emission control signal and the second signal (Cl2n) has the same polarity as the scan signal and is wider than the scan signal.

13. An organic light emitting display device, comprising:

pixels coupled to scan lines and data lines;
a scan driver configured to sequentially supply a scan signal to the scan lines; and
a data driver configured to supply a data signal to the data lines,
wherein each of the pixels comprises a pixel according to any one of the preceding claims.

**Patentansprüche**

1. Pixel (240), umfassend:

eine organische lichtemittierende Diode LED, die dazu ausgebildet ist, Licht als Reaktion auf ein Datensignal abzugeben;
eine organische lichtemittierende Dummy-Diode DOLED, die dazu ausgebildet ist,
sich in einem im Wesentlichen kein Licht abgebenden Zustand zu befinden, der von dem Datensignal unabhängig ist;
einen Transistor (M2) mit einer Gate-Elektrode, der dazu ausgebildet ist, der organischen lichtemittierenden Diode als Reaktion auf das Datensignal Strom zuzuführen; und

einen Kompensator (242), der mit der organischen lichtemittierenden Dummy-Diode gekoppelt ist;
**dadurch gekennzeichnet, dass**
der Kompensator dazu ausgebildet ist, eine Spannung an der Gate-Elektrode gemäß der Schwellenspannungsdifferenz zwischen der organischen lichtemittierenden Diode und der organischen lichtemittierenden Dummy-Diode zu ändern.

2. Pixel nach Anspruch 1, wobei der Transistor einen zweiten Transistor (M2) umfasst, wobei das Pixel weiterhin umfasst:

einen ersten Transistor (M1), der mit Abtastzeilen und Datenleitungen gekoppelt ist,
wobei der erste Transistor eingeschaltet wird, wenn der Abtastzeile ein Abtastsignal zugeführt wird,
einen Speicherkondensator (Cst), der dazu ausgebildet ist, eine Spannung zu laden,
die dem der Datenleitung zugeführten Datensignal entspricht;
wobei der Kompensator zwischen die organische lichtemittierende Diode und die organische lichtemittierende Dummy-Diode geschaltet ist.

3. Pixel nach Anspruch 2, weiterhin umfassend einen dritten Transistor (M3), der zwischen den zweiten Transistor (M2) und die organische lichtemittierende Diode geschaltet ist, wobei der zweite Transistor abgeschaltet wird, während das Abtastsignal zugeführt wird.

4. Pixel nach Anspruch 3, wobei der dritte Transistor mit einer Emissionssteuerleitung gekoppelt ist, wobei der dritte Transistor abgeschaltet wird, wenn der Emissionssteuerleitung ein Emissionssteuersignal zugeführt wird.

5. Pixel nach Anspruch 4, wobei das Emissionssteuersignal breiter ist als das Abtastsignal und das Abtastsignal überlappt.

6. Pixel nach einem der Ansprüche 2 bis 5, wobei der Kompensator umfasst:

einen vierten und fünften Transistor (M4, M5), die zwischen die organische lichtemittierende Diode und die organische lichtemittierende Dummy-Diode geschaltet sind; und
einen Feedback-Kondensator (Cfb), der zwischen die Gate-Elektrode des zweiten Transistors und einen gemeinsamen Knoten des vierten und fünften Transistors geschaltet ist.

7. Pixel nach Anspruch 6, wobei sich die Einschaltzeiten des vierten und fünften Transistors nicht überlappen.

8. Pixel nach Anspruch 7, wobei der vierte Transistor während eines Zeitraums eingeschaltet wird, wenn die dem Datensignal entsprechende Spannung im Speicherkondensator geladen wird und wenn dem Knoten eine Schwellenspannung der organischen lichtemittierenden Diode zugeführt wird.

9. Pixel nach Anspruch 8, wobei der fünfte Transistor während eines Zeitraums eingeschaltet wird, wenn der vierte Transistor abgeschaltet ist und wenn dem Knoten eine Schwellenspannung der organischen lichtemittierenden Dummy-Diode zugeführt wird.

10. Pixel nach einem der Ansprüche 6 bis 9, wobei der Feedback-Kondensator angeordnet ist zum Empfangen der Schwellenspannung der organischen lichtemittierenden Diode gemäß einem ersten Signal sowie zum Empfangen der Schwellenspannung der organischen lichtemittierenden Dummy-Diode gemäß einem zweiten Signal.

11. Pixel nach Anspruch 10, wobei das erste Signal ein Abtastsignal ist und das zweite Signal ein Emissionssteuersignal ist.

12. Pixel nach Anspruch 10, wobei das erste Signal (CL1 n) dieselbe Polarität aufweist wie das Emissionssteuersignal und breiter ist als das Emissionssteuersignal, und das zweite Signal (Cl2n) dieselbe Polarität aufweist wie das Abtastsignal und breiter ist als das Abtastsignal.

13. Organische lichtemittierende Anzeigevorrichtung, umfassend:

mit Abtastzeilen und Datenleitungen gekoppelte Pixel;
ein Abtasttreiber, der dazu ausgebildet ist, den Abtastzeilen sequentiell ein Abtastsignal zuzuführen; und

ein Datentreiber, der dazu ausgebildet ist, den Datenleitungen ein Datensignal zuzuführen,
wobei jedes der Pixel ein Pixel nach einem der vorstehenden Ansprüche umfasst.

**Revendications**

1. Pixel (240) comprenant :

   une diode électroluminescente organique OLED constituée pour émettre de la lumière en réponse à un signal de donnée ;
   une fausse diode électroluminescente organique DOLED constituée pour être dans un état pratiquement non émetteur de lumière qui est indépendant du signal de donnée ;
   un transistor (M2) ayant une électrode de grille et constitué pour fournir du courant à la diode électroluminescente organique en réponse au signal de donnée ; et
   un compensateur (242) associé à la fausse diode électroluminescente organique,
   **caractérisé en ce que** le compensateur est constitué pour changer la tension à l'électrode de grille en fonction de la différence de tensions de seuil de la diode électroluminescente organique et de la fausse diode électroluminescente organique.

2. Pixel selon la revendication 1, dans lequel le transistor comprend un deuxième transistor (M2), le pixel comprenant en outre :

   un premier transistor (M1) raccordé à des lignes de balayage et de donnée, le premier transistor étant rendu conducteur lorsqu'un signal de balayage est fourni à la ligne de balayage ;
   un condensateur de stockage (Cst) constitué pour se charger jusqu'à une tension correspondant au signal de donnée fourni à la ligne de donnée ;
   dans lequel le compensateur est raccordé entre la diode électroluminescente organique et la fausse diode électroluminescente organique.

3. Pixel selon la revendication 2, comprenant en outre un troisième transistor (M3) raccordé entre le deuxième transistor (M2) et la diode électroluminescente organique, le deuxième transistor étant bloqué lorsque le signal de balayage est fourni.

4. Pixel selon la revendication 3, dans lequel le troisième transistor est raccordé à une ligne de commande d'émission, dans lequel le troisième transistor est bloqué lorsqu'un signal de commande d'émission est fourni à la ligne de commande d'émission.

5. Pixel selon la revendication 4, dans lequel le signal de commande d'émission est plus large que le signal de balayage, et chevauche le signal de balayage.

6. Pixel selon l'une quelconque des revendications 2 à 5, dans lequel le compensateur comprend :

   des quatrième et cinquième transistors (M4, M5) raccordés entre la diode électroluminescente organique et la fausse diode électroluminescente organique ; et
   un condensateur de contre-réaction (Cfb) raccordé entre l'électrode de grille du deuxième transistor et un noeud commun des quatrième et cinquième transistors.

7. Pixel selon la revendication 6, dans lequel les périodes de conduction des quatrième et cinquième transistors ne se chevauchent pas.

8. Pixel selon la revendication 7, dans lequel le quatrième transistor est rendu conducteur durant une période où la tension correspondant au signal de donnée est chargée dans le condensateur de stockage et où la tension de seuil de la diode électroluminescente organique est fournie au noeud.

9. Pixel selon la revendication 8, dans lequel le cinquième transistor est rendu conducteur durant une période où le quatrième transistor est bloqué et où la tension de seuil de la fausse diode électroluminescente organique est fournie au noeud.

**10.** Pixel selon l'une quelconque des revendications 6 à 9, dans lequel le condensateur de contre-réaction est agencé pour recevoir la tension de seuil de la diode électroluminescente organique en fonction d'un premier signal, et pour recevoir la tension de seuil de la fausse diode électroluminescente organique en fonction d'un second signal.

**11.** Pixel selon la revendication 10, dans lequel le premier signal est un signal de balayage et le second signal est un signal de commande d'émission.

**12.** Pixel selon la revendication 10, dans lequel le premier signal (CL1n) a la même polarité que le signal de commande d'émission et est plus large que le signal de commande d'émission et le second signal (Cl2n) a la même polarité que le signal de balayage et est plus large que le signal de balayage.

**13.** Dispositif d'affichage électroluminescent organique, comprenant :

des pixels raccordés à des lignes de balayage et à des lignes de donnée ;
un circuit d'attaque de balayage constitué pour fournir séquentiellement un signal de balayage aux lignes de balayage ; et
un circuit d'attaque de donnée constitué pour fournir un signal de donnée aux lignes de donnée,
dans lequel chacun des pixels est composé d'un pixel selon l'une quelconque des revendications précédentes.

# FIG. 1

# FIG. 2

# FIG. 3

240

# FIG. 4

240

## FIG. 5

## FIG. 6

240

**EP 2 219 174 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008211397 A1

- EP 1923857 A2